# EUROPEAN PATENT APPLICATION

(11) **EP 3 822 957 A1**
(43) Date of publication of application: **19.05.2021**
(21) Application number: 20200017.0
(22) Date of filing: 05.10.2020
(51) Int. Cl.: G09G 3/20, G09G 3/32, G09G 3/36

(54) **ENHANCED COLOR GAMUT FOR ELECTRONIC DISPLAYS**

(30) Priority: 12.11.2019 US 201962934281 P
(71) Applicant: Daktronics, Inc., Brookings, SD 57006-5128 (US)
(72) Inventor: CARLSON, Shane Steven, Estelline, SD 57234 (US); MUELLER, Matthew Ray, Brookings, SD 57006 (US)
(74) Representative: Schwegman Lundberg Woessner Limited

(57) **Abstract**

An electronic display comprises an array of pixels of light-emitting elements, wherein each pixel is configured to emit a first primary color having a first wavelength, a second primary color having a second wavelength, a third primary color having a third wavelength, and a first gamut-enhancing color having a fourth wavelength that is within a first specified wavelength variance from the first wavelength, wherein a color gamut that can be produced by the array of pixels is greater than a corresponding array of corresponding pixels of corresponding light-emitting elements that are configured to only emit the first primary color having the first wavelength, the second primary color having the second wavelength, and the third primary color having the third wavelength.

## Description

### CROSS-REFERENCE TO RELATED APPLICTIONS

This application claims the benefit of priority to U.S. Provisional Patent Application Serial No. 62/934,281 entitled "ENHANCED COLOR GAMUT FOR ELECTRONIC DISPLAYS," filed November 12, 2019.

### BACKGROUND

Color electronic information displays are used for many applications, such as for dynamic billboard displays or scoreboards. These displays use pixels comprising a plurality of "primary" colored light-emitting elements that can be combined in various combinations of intensity to produce a variety of colors beyond the primary colors themselves. The combined range of color that the display is capable of producing is typically referred to as the display's "color gamut," or simply the "gamut."

One of the most common primary color combinations used for electronic displays comprises a combination of red, green, and blue light-emitting elements, typically referred to as an "RGB display." While RGB displays have a gamut that includes a large percentage of naturally-occurring colors, the potential color gamut for the display is still limited, with the full gamut available to the display being determined by the specific technology used for the light-emitting elements (with the most common being light-emitting diodes "LEDs").

It has been found that if the display is included with at least one additional color source, the color gamut that is possible for the electronic display can be increased. For example, in 2010, Sharp introduced its Quattron technology, which added an amber-colored subpixel to the conventional red, green, and blue subpixels to enhance the total color gamut.

### SUMMARY

The invention is an electronic display as defined in the appended claims. The present disclosure describes an electronic display with a color gamut that is enhanced compared to the gamut available from conventional RGB displays. The electronic display comprises pixels that emit three or more primary colors of light, i.e., a first primary color having a first light wavelength (e.g., red), a second primary color having a second wavelength (e.g., blue), and a third primary color having a third wavelength (e.g., green). The pixels of the electronic display are also configured to emit a first additional color of light with a fourth wavelength that varies from the first wavelength by a specified first variance, wherein the specified variance is selected to enhance the color gamut that is achievable by the electronic display compared to a corresponding display with pixels that emit only the first, second, and third primary colors. In some examples, the pixels of the display are also configured to emit a second additional color of light with a fifth wavelength that varies from the second wavelength by a specified second variance. In yet another example, the pixels of the display are also configured to emit a third additional color of light with a sixth wavelength that varies from the third wavelength by a specified third variance. The specific number of additional colors that the pixels are configured to emit and the specific variance from the first, second, or third wavelengths are selected to achieve a specified color gamut.

### BRIEF DESCRIPTION OF THE DRAWINGS

The drawings illustrate generally, by way of example, but not by way of limitation, various embodiments discussed in the present document.
**FIG. 1** is a partial perspective view of an example display comprising a plurality of individual display modules that are operated in a cooperative manner to display information on the light-emitting display.
**FIG. 2** is a perspective view of an example display module, which can be used as one of the individual display modules in the example display of FIG. 1.
**FIG. 3** is a front view of a conventional RGB display.
**FIG. 4** is a grayscale representation of the CIE 1976 L*, u*, v* color space ("CIELUV") overlaid with the color space of natural surface colors that can be seen by the human eye, the ITU-R Recommendation BT.2020 color gamut, the color gamut of a conventional RGB LED display, and an enhanced color gamut in accordance with various embodiments of the present disclosure.
**FIGS. 5A-5D** are front views of various enhanced-gamut displays with one or more additional gamut-enhancing light-emitting elements per pixel, in accordance with various embodiments of the present disclosure.
**FIGS. 6A-6C** are front views of various enhanced-gamut displays wherein one or more of the light-emitting elements in each pixel are modulated to emit both a primary color and a gamut-enhancing color, in accordance with various embodiments of the present disclosure.

### DETAILED DESCRIPTION

The following detailed description includes references to the accompanying drawings, which form a part of the detailed description. The drawings show, by way of illustration, specific embodiments in which the invention may be practiced. These embodiments, which are also referred to herein as "examples," are described in enough detail to enable those skilled in the art to practice the invention. The example embodiments may be combined, other embodiments may be utilized, or structural, and logical changes may be made without departing from the scope of the present invention. While the disclosed subject matter will be described in conjunction with the enumerated claims, it will be understood that the exemplified subject matter is not intended to limit the claims to the disclosed subject matter. The following detailed description is, therefore, not to be taken in a limiting sense, and the scope of the present invention is defined by the appended claims and their equivalents.

References in the specification to "one embodiment", "an embodiment," "an example embodiment," etc., indicate that the embodiment described can include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

Values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a concentration range of "about 0.1% to about 5%" should be interpreted to include not only the explicitly recited concentration of about 0.1 wt. % to about 5 wt. %, but also the individual concentrations (e.g., 1%, 2%, 3%, and 4%) and the sub-ranges (e.g., 0.1% to 0.5%, 1.1% to 2.2%, and 3.3% to 4.4%) within the indicated range. The statement "about X to Y" has the same meaning as "about X to about Y,"" unless indicated otherwise. Likewise, the statement "about X, Y, or about Z" has the same meaning as "about X, about Y, or about Z," unless indicated otherwise.

In this document, the terms "a," "an," or "the" are used to include one or more than one unless the context clearly dictates otherwise. The term "or" is used to refer to a nonexclusive "or" unless otherwise indicated. Unless indicated otherwise, the statement "at least one of' when referring to a listed group is used to mean one or any combination of two or more of the members of the group. For example, the statement "at least one of A, B, and C" can have the same meaning as "A; B; C; A and B; A and C; B and C; or A, B, and C," or the statement "at least one of D, E, F, and G" can have the same meaning as "D; E; F; G; D and E; D and F; D and G; E and F; E and G: F and G; D, E, and F; D, E, and G; D, F, and G; E, F, and G; or D, E, F, and G." A comma can be used as a delimiter or digit group separator to the left or right of a decimal mark; for example, "0.000,1"" is equivalent to "0.0001."

In the methods described herein, the steps can be carried out in any order without departing from the principles of the invention, except when a temporal or operational sequence is explicitly recited. Furthermore, specified steps can be carried out concurrently unless explicit language recites that they be carried out separately. For example, a recited act of doing X and a recited act of doing Y can be conducted simultaneously within a single operation, and the resulting process will fall within the literal scope of the process. Recitation in a claim to the effect that first a step is performed, and then several other steps are subsequently performed, shall be taken to mean that the first step is performed before any of the other steps, but the other steps can be performed in any suitable sequence, unless a sequence is further recited within the other steps. For example, claim elements that recite "Step A, Step B, Step C, Step D, and Step E" shall be construed to mean step A is carried out first, step E is carried out last, and steps B, C, and D can be carried out in any sequence between steps A and E (including with one or more steps being performed concurrent with step A or Step E), and that the sequence still falls within the literal scope of the claimed process. A given step or sub-set of steps can also be repeated.

Furthermore, specified steps can be carried out concurrently unless explicit claim language recites that they be carried out separately. For example, a claimed step of doing X and a claimed step of doing Y can be conducted simultaneously within a single operation, and the resulting process will fall within the literal scope of the claimed process.

The term "about" as used herein can allow for a degree of variability in a value or range, for example, within 10%, within 5%, within 1%, within 0.5%, within 0.1%,, within 0.05%, within 0.01%, within 0.005%, or within 0.001% of a stated value or of a stated limit of a range, and includes the exact stated value or range.

The term "substantially" as used herein refers to a majority of, or mostly, such as at least about 50%, 60%, 70%, 80%, 90%, 95%, 96%, 97%, 98%, 99%, 99.5%, 99.9%, 99.99%, or at least about 99.999% or more, or 100%.

In addition, it is to be understood that the phraseology or terminology employed herein, and not otherwise defined, is for the purpose of description only and not of limitation.

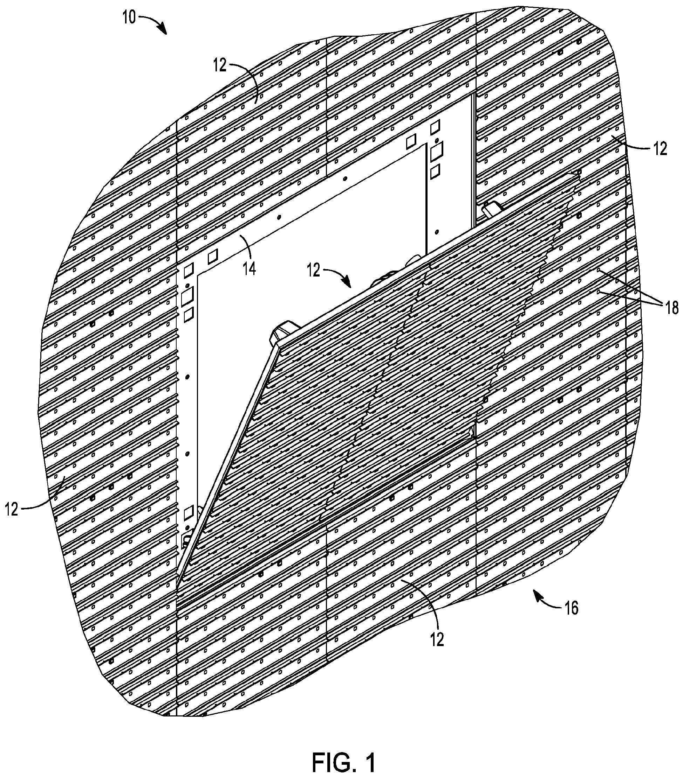

FIG. 1 is a perspective view of an example information display 10 (also referred to simply as "display 10") that can include the color gamut enhancements described herein. The display 10 is configured to display one or more of video, graphical, or textual information. The display 10 includes one or more individual display modules 12 mounted to one or more supports, such as a support chassis 14. In examples wherein the display 10 is formed from a plurality of the display modules 12, the plurality of display modules 12 operate together so that the overall display 10 appears as a single, larger display. FIG. 1 shows one of the display modules 12 being in a pivoted or tilted position relative to the support chassis 14, which can occur when that display module 12 is in the process of being mounted to or dismounted from the support chassis 14 while the other display modules 12 in the display 10 have already been mounted to the support chassis 14. The display 10 can include a display surface 16 configured to display the video, graphical, or textual information from the display 10. A plurality of light-emitting elements 18 is mounted to the display surface 16. For example, light-emitting elements 18 can be mounted to one or more module support structures on each of the display module 12, such as one or more of a circuit board, potting, or a module frame of a corresponding display module 12. The light-emitting elements 18 are operated together to display the video, graphical, or textual information on the display 10.

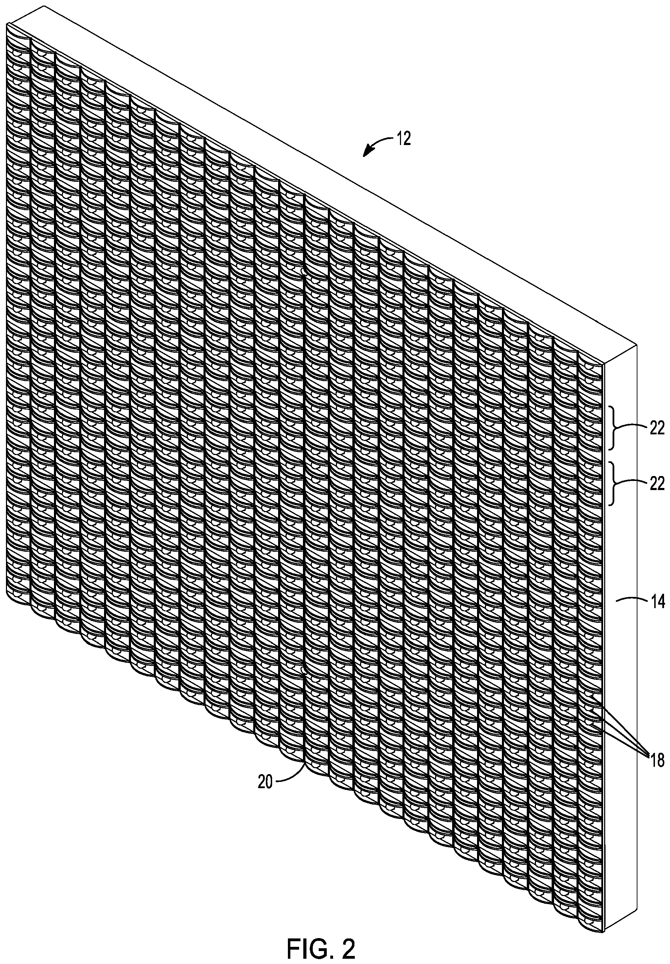

The light-emitting elements 18 can be any type of light-emitting technology known or yet to be discovered for the emission of light from a small area (e.g., from a pixel area), particularly for light-emitting technology that is or can be used to display visual information, such as video, graphical, or textual information. At the time of filing of the present application, light-emitting diodes (LEDs) are one of the most common light-emitting technologies in use for video or graphical displays of the type described herein. As such, for the sake of brevity, the remainder of the present disclosure will refer to light-emitting elements that can be used in a display (including the light-emitting elements 18 shown in FIGS. 1 and 2) as LEDs. Those of skill in the art will appreciate, however, that any time the present disclosure uses the term "light-emitting diode" or "LED," that light-emitting devices other than LEDs can be used, including, but not limited to, liquid crystal display devices (LCDs), organic light-emitting diodes (OLEDs), organic light-emitting transistors (OLETs), surface-conduction electron-emitter display devices (SEDs), field-emission display devices (FEDs), laser TV quantum dot liquid crystal display devices (QD-LCDs), quantum dot light-emitting diode display devices (QD-LEDs), ferro-liquid display devices (FLDs), and thick-film dielectric electroluminescent devices (TDELs).

FIG. 2 is a perspective view of an example display module 12 that can be used in the display 10 of FIG. 1. The display module 12 includes a front face 20 configured to provide for a display of graphics or video content. A plurality of the LEDs 18 is mounted to the front face 20 by being mounted onto a module support structure, such as an electronics circuit board or a module frame. The LEDs 18 can be operated in such a way that the display module 12 will display a portion of the video, graphical, or textual information to be shown on the display 10. The front face 20 of the display module 12 is aligned and oriented relative to front faces 20 of one or more adjacently-positioned display modules 12 so that the front faces 20 combine and cooperatively form the overall display surface 16 of the full display 10 (shown in FIG. 1). The plurality of display modules 12 are operated together in such a way as to display the video, graphical, or textual information in a cohesive manner so that the entire display 10 appears to a viewer as a single display that is larger than the individual display modules 12.

The LEDs 18 are arranged into an array of pixels 22 (best seen in FIG. 2). Each pixel 22 includes three or more LEDs 18 grouped together in close proximity. The proximity of the pixels 22 allows the display 10 to be operated in such a way that they will appear to a viewer of the display 10 to form recognizable shapes, such as letters or numbers to display textual information or recognizable shapes to display graphical or video information. The plurality of LEDs 18 includes a plurality of different-colored LEDs 18 such that different-colored LEDs 18 of each pixel 22 can be cooperatively operated to display what appears to be a spectrum of different colors for the viewer of the display 10. In an example, each pixel 22 includes three or more colors that are selected to provide for a large gamut of colors that can be produced at each pixel 22 of the display 10. These colors are typically referred to as "primary colors," and they can, when combined with different intensities, produce each color within the overall gamut. One of the most common combinations of primary colors for light-emitting displays such as the display 10 are red, green, and blue (also referred to as "RGB"). Therefore, in an example, each pixel 22 includes at least one red LED 18, at least one green LED 18, and at least one blue LED 18. The display 10 can also provide a black or empty looking surface over a portion of the display, when desired, by deactivating or turning off the LEDs 18 in a designated area of pixels 22.

Although FIGS. 1 and 2 show an example display with a plurality of display modules, the color-gamut enhancement of the present disclosure is not limited to use with a modular display. Rather, those having skill in the art will appreciate that other display configurations can be used without varying from the scope of the present invention.

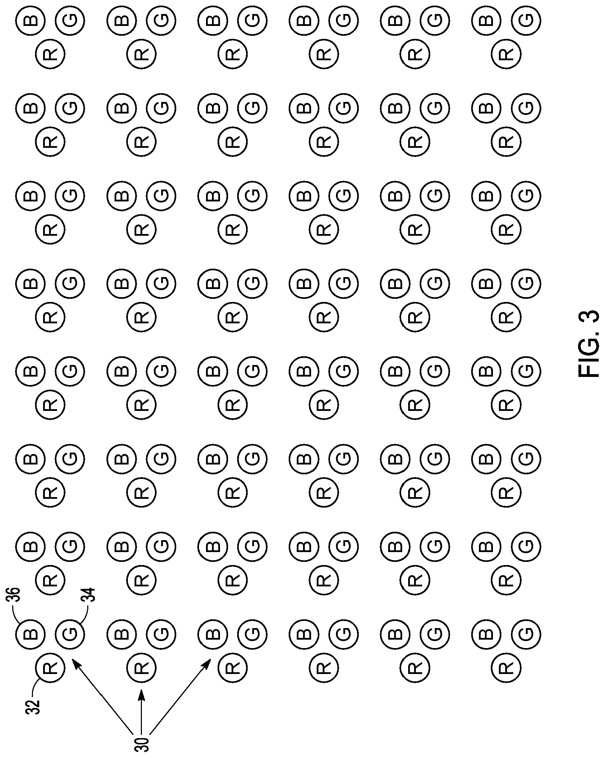

FIG. 3 shows a close-up view of an example configuration for pixels 30 in a conventional RGB display. The conventional RGB configuration includes three LEDs in each pixel 30, one for each of the three primary colors, i.e., a red LED 32, a green LED 34, and a blue LED 36. The configuration of the pixels 30 shown in FIG. 3 could be used on the example display 10 and display module 12 of FIGS. 1 and 2. In an example that is common in commercially-available displays, the red LEDs 32 emit red light at a wavelength of from about 615 nanometers ("nm") to about 620 nm, the green LEDs 34 emit green light at a wavelength of from about 530 nm to about 535 nm, and the blue LEDs 36 emit blue light at a wavelength of from about 470 nm to about 475 nm.

The physical configuration of the pixels in FIG. 3 is shown as a generally triangular configuration, e.g., with each light-emitting element at the vertex of an equilateral triangle. However, those having skill in the art will appreciate that the displays of the present disclosure are not limited to the triangular configuration shown in FIG. 3 or to any other configuration, and that other specific layouts of the light-emitting elements in the pixels can be used including, but not limited to, a linear pixel (e.g., with each light-emitting element arranged generally or substantially along the same line, which can be vertical or substantially vertical as in the example of FIG. 2), horizontal or substantially horizontal, or diagonal), a non-equilateral triangle, or a non-regular geometric shape.

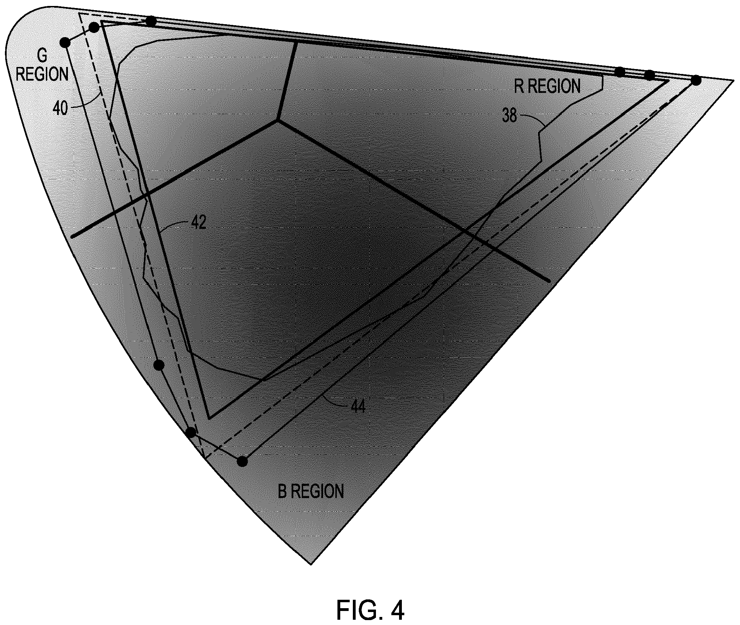

FIG. 4 is a grayscale version of the uniform color space ("UCS") adopted by the International Commission on Illumination (also known as "Commission Internationale de l'éclairage," or "CIE"), sometimes referred to as the CIE 1976 L*, u*, v* color space, more commonly known by its abbreviation "CIELUV." As will be appreciated with those of skill in the art who are familiar with the CIELUV color space, the CIELUV has a rounded triangular shape with three corner regions corresponding to three primary light colors, i.e., red light (labeled as the "R REGION" in FIG. 4), green light (labeled as the "G REGION" in FIG. 4), and blue light (labeled as the "B REGION" in FIG. 4), with the three primary color regions being divided by black lines (which do not typically appear in full-color representations of the CIELUV color space).

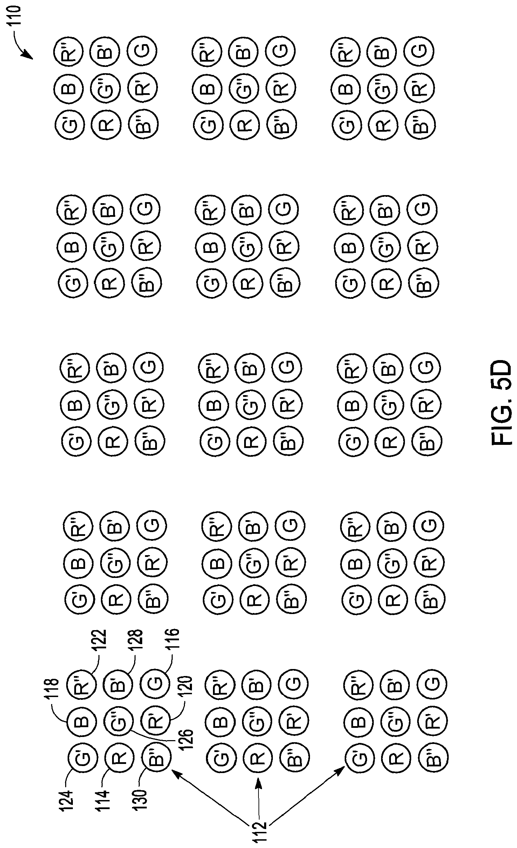

The CIELUV color space shown in FIG. 4 also includes a conceptual representation of the color space of natural surface colors that can be seen by the human eye (also known as "Pointer's Gamut"), which is bounded by the boundary line 38. The color space of FIG. 4 also includes a conceptual representation of the colors that are part of the color gamut from the ITU-R Recommendation BT.2020 as recommended by the International Telecommunication Union ("ITU"), which will be referred to hereinafter as the "Rec 2020 colors" or the "Rec 2020 color space," which is bounded by the dashed boundary line 40 FIG. 4 further includes a conceptual representation of the color gamut that is achievable by a conventional RGB display, e.g., one using the LED pixel configuration 30 shown in FIG. 3, which is bounded by the boundary line 42. As can be seen in FIG. 4, the color gamut 42 achievable with the conventional RGB LED display does not include the entirety of the naturally-occurring color space 38 and includes only about 75-80% of the Rec 2020 color space 40. Finally, FIG. 4 includes a conceptual representation of the color gamut that is achievable by the display 110 shown in FIG. 5D, which is bounded by the boundary line 44 with black vertex points. As can be seen in FIG. 4, the color gamut 44 that is achievable with the enhanced-gamut display 110 of the present disclosure is able to cover all of the naturally-occurring color space 38 and about 98% of the Rec 2020 color space 40, which is substantially more than the amount that is covered by the conventional RGB gamut 42.

The present disclosure describes an electronic display with a color gamut that is enhanced compared to the gamut available from conventional RGB displays. In order to provide the enhanced color gamut, the electronic displays of the present disclosure comprise pixels that emit three or more primary colors of light. For example, the display pixels emit a first primary color having a first light wavelength (e.g., green light having a wavelength of about 530-535 nm), a second primary color having a second wavelength (e.g., blue light having a wavelength of about 470-475 nm), and a third primary color having a third wavelength (e.g., red light having a wavelength of about 605-620 nm). The pixels of the electronic display are also configured to emit one or more additional colors of light, also referred to as "gamut-enhancing colors" or simply "enhancing colors," for one, two, or all three of the primary colors.

Each gamut-enhancing color has a wavelength that is within a specified variance from the wavelength of a corresponding one of the primary colors. In this way, each gamut-enhancing color is visually similar to its corresponding primary color but has a wavelength that is different enough from the wavelength of the corresponding primary color such that the resulting color gamut that can be achieved by the display is larger than a corresponding gamut for a display that only emits the three primary color wavelengths, e.g., a conventional RGB display.

In a specific example, the pixels of the display are configured to emit a first gamut-enhancing color with a fourth wavelength that varies from the first wavelength by a specified first variance. For example, if the first primary color is green light (e.g., with a first wavelength of about 530-535 nm), then a first gamut-enhancing color can be a different shade of "green" with a wavelength that is at least about 15 nm away from the first wavelength and also less about 50 nm away from the first wavelength (e.g., from about 510 nm to about 530 nm or from about 535 nm to about 550 nm). In another example, the second primary color is blue light (e.g., with a second wavelength of about 470-475 nm), and a second gamut-enhancing color can be a different shade of "blue" with a wavelength that is at least about 15 nm away from the second wavelength and also less about 50 nm away from the second wavelength (e.g., from about 450 nm to about 470 nm or from about 475 nm to about 485 nm) In yet another example, the third primary color is red light (e.g., with a third wavelength of about 615-620 nm), then the first gamut-enhancing color can be a different shade of "red" with a wavelength that is at least about 15 nm away from the third wavelength and also less about 50 nm away from the third wavelength (e.g., from about 605 nm to about 6015 nm or from about 620 nm to about 635 nm). Although the specified variance is described as being the same for each corresponding primary color, e.g., from about 15 nm to about 50 nm for the red, green, and blue gamut-enhancing colors, those having skill in the art will appreciate that the specified wavelength variance can differ for each of the primary colors (e.g., a first wavelength variance for the first gamut-enhancing color, a second variance for the second gamut-enhancing color that can be the same or different from the first wavelength variance, and a third wavelength variance for the third gamut-enhancing color that can be the same or different from the first and second wavelength variances).

The specified variance is selected to enhance the color gamut that is achievable by the electronic display compared to a corresponding display with pixels that emit only the first, second, and third primary colors. The specific number of gamut-enhancing colors that the pixels are configured to emit and the specific variance from the first, second, or third wavelengths are selected to achieve a specified color gamut.

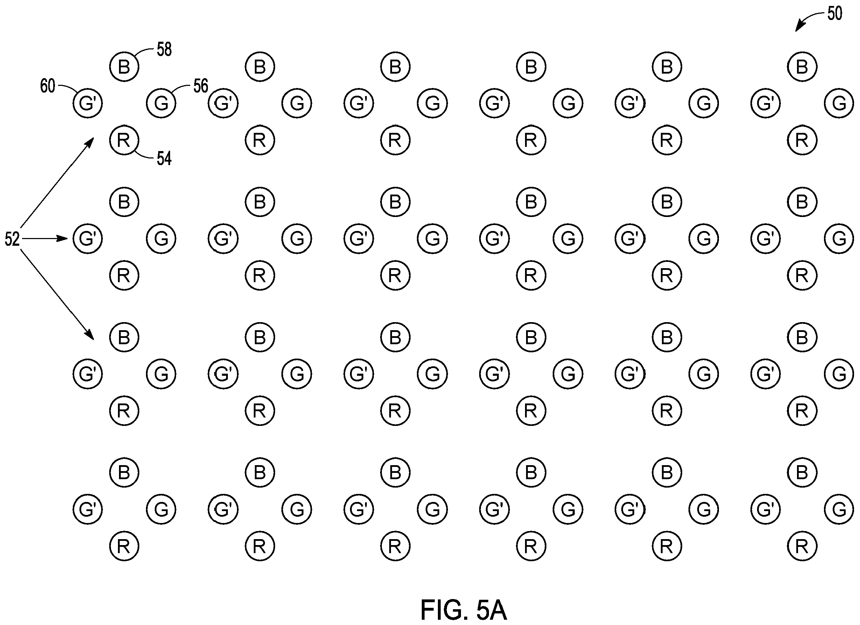

The display can be configured in more than one way to emit the one or more gamut-enhancing colors from its pixels. In one example, shown in FIGS. 5A-5D, the pixels of the display can each include an additional LED for each gamut-enhancing color. For example, FIG. 5A shows an example display 50 wherein each pixel 52 includes the three primary LEDs, e.g., a red primary LED 54, a green primary LED 56, and a blue primary LED 58, and one gamut-enhancing LED 60 that emits light with a wavelength that is within a specified variance (e.g., from about 15 nm to about 50 nm) of the corresponding wavelength of one of the primary color LEDs 54, 56, 58. In the example shown in FIG. 5A, the gamut-enhancing LED 60 corresponds to the green primary LED 56 (designated G' (G prime) for the gamut-enhancing LED 60), i.e., the wavelength emitted from the gamut-enhancing LED 60 is within the specified variance from the wavelength emitted by the green primary LED 56. Those having skill in the art will appreciate, however, that the gamut-enhancing LED 60 could correspond to the red primary LED 54 or the blue primary LED 58 rather than the green primary LED 56.

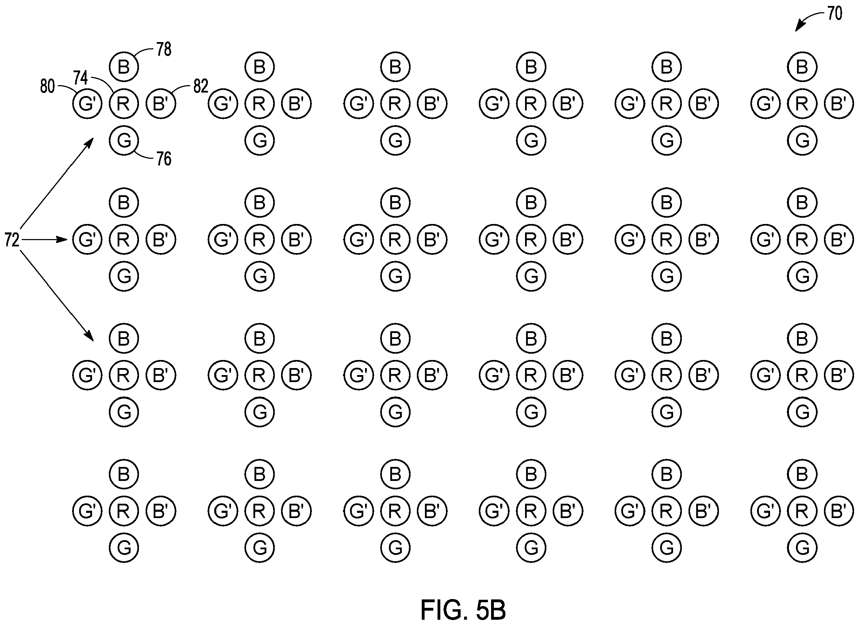

FIG. 5B shows another example display 70 wherein each pixel 72 includes the three primary LEDs, e.g., a red primary LED 74, a green primary LED 76, and a blue primary LED 78, and two gamut-enhancing LEDs 80 and 82 that each emit light with a wavelength that is within a specified variance (e.g., from about 15 nm to about 50 nm) of a corresponding wavelength of a corresponding one of the primary LEDs 74, 76, 78. In the example shown in FIG. 5B, the first gamut-enhancing LED 80 corresponds to the green primary LED 76 (designated G' (G prime) for the first gamut-enhancing LED 80) and the second gamut-enhancing LED 82 corresponds to the blue primary LED 78 (designated B' (B prime) for the second gamut-enhancing LED 82), i.e., the wavelength emitted from the first gamut-enhancing LED 80 is within a first specified variance from the wavelength emitted by the green primary LED 76 and the wavelength emitted from the second gamut-enhancing LED 82 is within a second specified variance from the wavelength emitted by the blue primary LED 78. Those having skill in the art will appreciate, however, that either the first gamut-enhancing LED 80 or the second gamut-enhancing LED 82 could correspond to the red primary LED 74 rather than the green primary LED 76 or the blue primary LED 78.

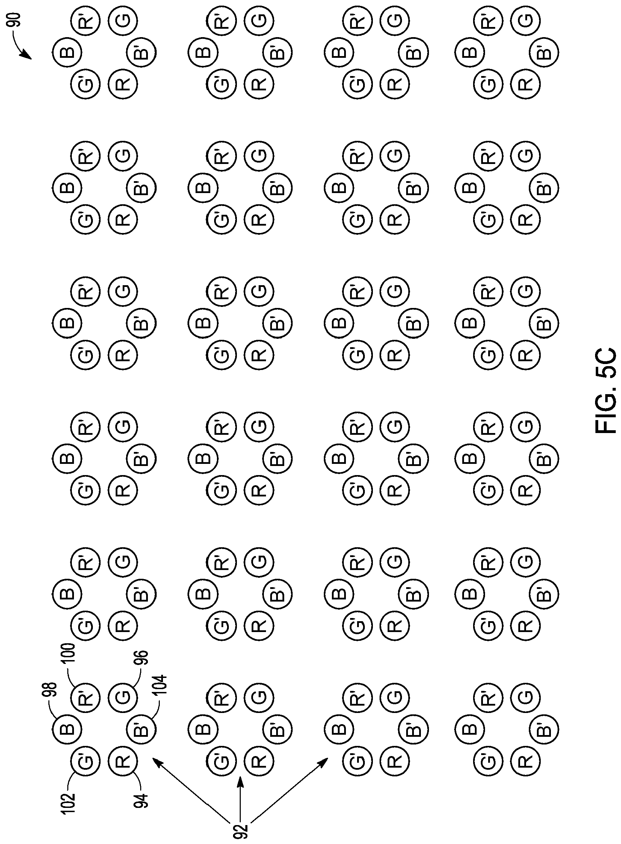

FIG. 5C shows another example display 90 wherein each pixel 92 includes the three primary LEDs, e.g., a red primary LED 94, a green primary LED 96, and a blue primary LED 98, and three gamut-enhancing LEDs 100, 102, and 104 that each emit light with a wavelength that is within a specified variance (e.g., from about 15 nm to about 50 nm) of a corresponding wavelength of a corresponding one of the primary LEDs 94, 96, 98. In the example shown in FIG. 5C, the first gamut-enhancing LED 100 corresponds to the red primary LED 94 (designated R' (R prime) for the first gamut-enhancing LED 100), the second gamut-enhancing LED 102 corresponds to the green primary LED 96 (designated G' (G prime) for the second gamut-enhancing LED 102), and the third gamut-enhancing LED 104 corresponds to the blue primary LED 98 (designated B' (B prime) for the third gamut-enhancing LED 104), i.e., the wavelength emitted from the first gamut-enhancing LED 100 is within a first specified variance from the wavelength emitted by the red primary LED 94, the second gamut-enhancing LED 102 is within a second specified variance from the wavelength emitted by the green primary LED 96, and the wavelength emitted from the third gamut-enhancing LED 104 is within a third specified variance from the wavelength emitted by the blue primary LED 108.

FIG. 5D shows yet another example display 110 wherein each pixel 112 includes the three primary LEDs, e.g., a red primary LED 114, a green primary LED 116, and a blue primary LED 118, and two gamut-enhancing LEDs for each of the primary colors, e.g., a first red gamut-enhancing LED 120 and a second red gamut-enhancing LED 122 (denoted as R' (R prime) and R" (R double prime), respectively, in FIG. 5D), a first green gamut-enhancing LED 124 and a second green gamut-enhancing LED 126 (denoted as G' (G prime) and G" (G double prime), respectively, in FIG. 5D), and a first blue gamut-enhancing LED 128 and a second blue gamut enhancing LED 130 (denoted as B' (B prime) and B" (B double prime), respectively, in FIG. 5D). Each gamut-enhancing LED 120, 122, 124, 126, 128, and 130 emits light with a wavelength that is within a specified variance (e.g., from about 15 nm to about 50 nm) of a corresponding wavelength of its corresponding primary LED 114, 116, 118.

Those having skill in the art will appreciate that each pixel 112 in the display 110 need not have two gamut-enhancing LEDs for all three primary colors, but rather could have two gamut-enhancing LEDs for only one of the primary colors (e.g., two green gamut-enhancing LEDs corresponding to the green primary LED), or only two of the primary colors (e.g., two green gamut-enhancing LEDs corresponding to the green primary LED and two blue gamut-enhancing LEDs corresponding to the blue primary LED) without varying from the scope of the present disclosure.

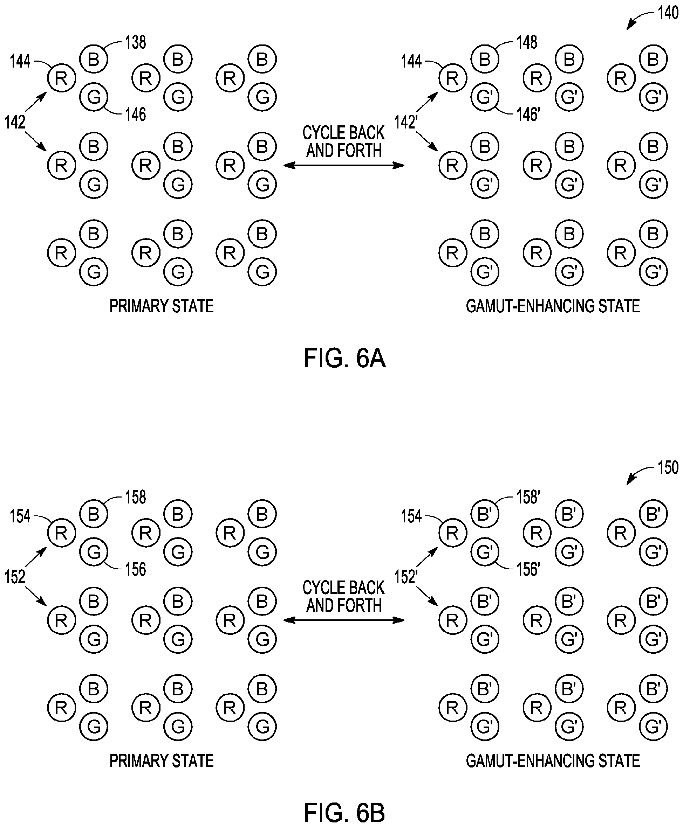

While the example displays 50, 70, 90, 110 of FIGS. 5A-5D provide the color gamut enhancement of the present disclosure by adding one or more additional physical LEDs beyond the primary color LEDs, the color enhancement need not be provided by a separate physical gamut-enhancing light-emitting element. FIGS. 6A-6C show example displays that provides for color gamut enhancement with pixels that have the same number of LEDs as the number of primary colors, e.g., three in the case of an RGB display. The color enhancement of the display is provided by modulating the wavelength that is emitted from one or more of the LEDs so that the one or more modulated LED emit both the corresponding primary color and a gamut-enhancing color that is within a specified variance of the wavelength of the corresponding primary color. In an example, two separate drive currents can be applied to each modulated LED, e.g., a primary drive current and a gamut-enhancing drive current, so that the modulated LED will emit both the primary color and the gamut-enhancing color. The modulated LED can cycle between applying the primary drive current and the gamut-enhancing drive current so that he modulated LED cycle between emitting the primary color and the gamut-enhancing color.

FIG. 6A shows an example display 140 with pixels 142 that include a red LED 144, a green LED 146, and a blue LED 148. The pixels 142 cycle between two states, a first state wherein all three LEDs 144, 146, and 148 emit their corresponding primary colors (where the pixels are designated with reference number 142, referred to hereinafter as the "primary state," shown on the left side of FIG. 6A) and a second state wherein one of the LEDs is changed to emit a gamut-enhancing color (where the pixels are designated with reference number 142' (142 prime), referred to hereinafter as the "gamut-enhancing state," shown on the right side of FIG. 6A). In the example shown in FIG. 6A, the red LED 144 and the blue LED 148 continue to emit the same primary red and primary blue colors when in the gamut-enhancing state, and the green LED 146 is cycled to emit both a primary green and a gamut-enhancing green (depicted by designating the green LED 146 with the reference number 146' (146 prime) when in the gamut-enhancing state). Those having skill in the art will appreciate, however, that the red LED 144 or the blue LED 148 could be cycled between emitting the primary color and gamut-enhancing color rather than the green LED 146.

FIG. 6B shows another example display 150 with pixels 152 that include a red primary 154, a green LED 156, and a blue LED 118. The pixels 152 cycle between two states, a primary state wherein all three LEDs 154, 156, and 158 emit their corresponding primary colors (where the pixels are designated with reference number 152, shown on the left side of FIG. 6B) and a gamut-enhancing state wherein two of the LEDs are changed to emit a gamut-enhancing color (where the pixels are designated with reference number 152' (152 prime), shown on the right side of FIG. 6B). In the example shown in FIG. 6B, the red LED 154 continues to emit the same primary red color when in the gamut-enhancing state, while the green LED 156 is cycled to emit both a primary green and a gamut-enhancing green (depicted by designating the green LED 156 with the reference number 156' (156 prime) when in the gamut-enhancing state) and the blue LED 158 is cycled to emit both a primary blue and a gamut-enhancing blue (depicted by designating the blue LED 158 with the reference numbers 158' (158 prime) when in the gamut-enhancing state). Those having skill in the art will appreciate, however, that the red LED 154 could be cycled between the primary color and a gamut-enhancing color in place of the cycling of either the green LED 156 or the blue LED 158.

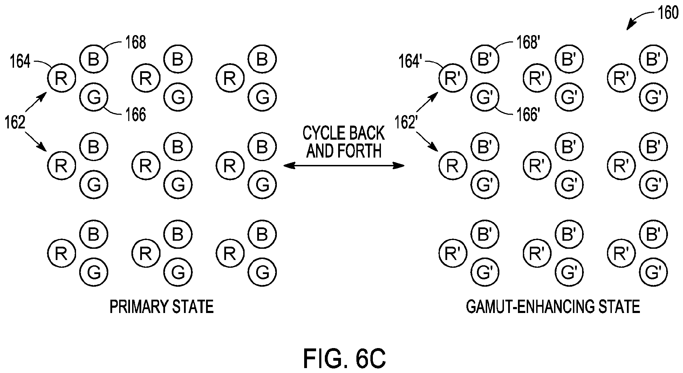

FIG. 6C shows another example display 160 with pixels 162 that include a red primary 164, a green LED 166, and a blue LED 168. The pixels 162 cycle between two states, a primary state wherein all three LEDs 164, 166, and 168 emit their corresponding primary colors (where the pixels are designated with reference number 162, shown on the left side of FIG. 6C) and a gamut-enhancing state wherein all three of the LEDs are changed to emit a gamut-enhancing color (where the pixels are designated with reference number 162' (162 prime), shown on the right side of FIG. 6C). In the example shown in FIG. 6C, the red LED 164 is cycled to emit both a primary red and a gamut-enhancing red (depicted by designating the red LED 164 with the reference number 164' (164 prime) when in the gamut-enhancing state), the green LED 166 is cycled to emit both a primary green and a gamut-enhancing green (depicted by designating the green LED 166 with the reference number 166' (166 prime) when in the gamut-enhancing state), and the blue LED 168 is cycled to emit both a primary blue and a gamut-enhancing blue (depicted by designating the blue LED 168 with the reference numbers 168' (168 prime) when in the gamut-enhancing state).

To better illustrate the present LED displays, modules, and methods, a nonlimiting list of EXAMPLES is provided here:
EXAMPLE 1 can include subject matter (such as an apparatus, a device, a method, or one or more means for performing acts), such as can include an electronic display comprising an array of pixels of light-emitting elements, wherein each pixel is configured to emit a first primary color having a first wavelength, a second primary color having a second wavelength, a third primary color having a third wavelength, and a first gamut-enhancing color having a fourth wavelength that is within a first specified wavelength variance from the first wavelength, wherein a color gamut that can be produced by the array of pixels is greater than a corresponding color gamut that can be produced by a corresponding array of corresponding pixels of corresponding light-emitting elements that are configured to only emit the first primary color having the first wavelength, the second primary color having the second wavelength, and the third primary color having the third wavelength.
EXAMPLE 2 can include or can optionally be combined with the subject matter of EXAMPLE 1, to optionally include the first specified wavelength variance being from about 15 nanometers to about 50 nanometers.
EXAMPLE 3 can include or can optionally be combined with the subject matter of EXAMPLE 1 or EXAMPLE 2, to optionally include each pixel being configured to emit a second gamut-enhancing color with a fifth wavelength that is within a second specified wavelength variance from the second wavelength.
EXAMPLE 4 can include or can optionally be combined with the subject matter of EXAMPLE 3, to optionally include the second specified wavelength variance being from about 15 nanometers to about 50 nanometers.
EXAMPLE 5 can include or can optionally be combined with the subject matter of one or any combination of EXAMPLES 1-4, to optionally include each pixel being configured to emit a third gamut-enhancing color with a sixth wavelength that is within a third specified wavelength variance from the third wavelength.
EXAMPLE 6 can include or can optionally be combined with the subject matter of one or any combination of EXAMPLES 1-5, to optionally include the third specified wavelength variance being from about 15 nanometers to about 50 nanometers.
EXAMPLE 7 can include or can optionally be combined with the subject matter of one or any combination of EXAMPLES 1-6, to optionally include the first wavelength being within a first of a first wavelength range, a second wavelength range, and a third wavelength range; the second wavelength being within a second of the first wavelength range, the second wavelength range, and the third wavelength range; and the third wavelength being within a third of the first wavelength range, the second wavelength range, and the third wavelength range.
EXAMPLE 8 can include or can optionally be combined with the subject matter of EXAMPLE 7, to optionally include the first wavelength range being from about 470 nanometers to about 475 nanometers, the second wavelength range being from about 530 nanometers to about 535 nanometers, and the third wavelength range being from about 615 nanometers to about 620 nanometers.
EXAMPLE 9 can include or can optionally be combined with the subject matter of one or any combination of EXAMPLES 1-6, to optionally include the first wavelength being from about 615 nanometers to about 620 nanometers, the second wavelength being from about 530 nanometers to about 535 nanometers, and the third wavelength being from about 470 nanometers to about 475 nanometers.
EXAMPLE 10 can include or can optionally be combined with the subject matter of one or any combination of EXAMPLES 1-6, to optionally include the first wavelength being from about 615 nanometers to about 620 nanometers, the second wavelength being from about 470 nanometers to about 475 nanometers, and the third wavelength being from about 530 nanometers to about 535 nanometers.
EXAMPLE 11 can include or can optionally be combined with the subject matter of one or any combination of EXAMPLES 1-6, to optionally include the first wavelength being from about 530 nanometers to about 535 nanometers, the second wavelength being from about 615 nanometers to about 620 nanometers, and the third wavelength being from about 470 nanometers to about 475 nanometers.
EXAMPLE 12 can include or can optionally be combined with the subject matter of one or any combination of EXAMPLES 1-6, to optionally include the first wavelength being from about 530 nanometers to about 535 nanometers, the second wavelength being from about 470 nanometers to about 475 nanometers, and the third wavelength being from about 615 nanometers to about 620 nanometers.
EXAMPLE 13 can include or can optionally be combined with the subject matter of one or any combination of EXAMPLES 1-6, to optionally include the first wavelength being from about 470 nanometers to about 475 nanometers, the second wavelength being from about 615 nanometers to about 620 nanometers, and the third wavelength being from about 530 nanometers to about 535 nanometers.
EXAMPLE 14 can include or can optionally be combined with the subject matter of one or any combination of EXAMPLES 1-6, to optionally include the first wavelength being from about 470 nanometers to about 475 nanometers, the second wavelength being from about 530 nanometers to about 535 nanometers, and the third wavelength being from about 615 nanometers to about 620 nanometers.
EXAMPLE 15 can include or can optionally be combined with the subject matter of one or any combination of EXAMPLES 1-14, to include subject matter (such as an apparatus, a device, a method, or one or more means for performing acts), such as can include an electronic display comprising an array of pixels each comprising a first primary light-emitting element configured to emit a first primary color having a first wavelength, a second primary light-emitting element configured to emit a second primary color having a second wavelength, a third primary light-emitting element configured to emit a third primary color having a third wavelength, and a first gamut-enhancing light-emitting element configured to emit a first gamut-enhancing color having a fourth wavelength that is within a first specified wavelength variance from the first wavelength, wherein a color gamut that can be produced by the array of pixels is greater than a corresponding color gamut that can be produced by a corresponding array of corresponding pixels of corresponding light-emitting elements that are configured to only emit the first primary color having the first wavelength, the second primary color having the second wavelength, and the third primary color having the third wavelength.
EXAMPLE 16 can include or can optionally be combined with the subject matter of one or any combination of EXAMPLES 1-15, to optionally include each pixel further comprising a second gamut-enhancing light-emitting element configured to emit a second gamut-enhancing color having a fifth wavelength that is within a second specified wavelength variance from the second wavelength.
EXAMPLE 17 can include or can optionally be combined with the subject matter of one or any combination of EXAMPLES 1-16, to optionally include each pixel comprising a third gamut-enhancing light-emitting element configured to emit a third gamut-enhancing color having a sixth wavelength that is within a third specified wavelength variance from the third wavelength.
EXAMPLE 18 can include or can optionally be combined with the subject matter of one or any combination of EXAMPLES 1-17, to include subject matter (such as an apparatus, a device, a method, or one or more means for performing acts), such as can include an electronic display comprising an array of pixels each comprising a first primary light-emitting element configured to emit a first primary color having a first wavelength, a second primary light-emitting element configured to emit a second primary color having a second wavelength, a third primary light-emitting element configured to emit a third primary color having a third wavelength, a first gamut-enhancing light-emitting element configured to emit a first gamut-enhancing color having a fourth wavelength that is within a first specified wavelength variance from the first wavelength, and a second gamut-enhancing light-emitting element configured to emit a second gamut-enhancing color having a fifth wavelength that is within a second specified wavelength variance from the first wavelength, wherein a color gamut that can be produced by the array of pixels is greater than a corresponding color gamut that is produced by a corresponding array of corresponding pixels of corresponding light-emitting elements that are configured to only emit the first primary color having the first wavelength, the second primary color having the second wavelength, and the third primary color having the third wavelength.
EXAMPLE 19 can include or can optionally be combined with the subject matter of one or any combination of EXAMPLES 1-18, to optionally include the corresponding array of corresponding pixels of the corresponding light-emitting elements being configured to only emit the first primary color having the first wavelength, the second primary color having the second wavelength, the third primary color having the third wavelength, and the first gamut-enhancing color having the fourth wavelength.
EXAMPLE 20 can include or can optionally be combined with the subject matter of one or any combination of EXAMPLES 1-19, to optionally include the first specified wavelength variance being from about 15 nanometers to about 50 nanometers.
EXAMPLE 21 can include or can optionally be combined with the subject matter of one or any combination of EXAMPLES 1-20, to optionally include the second specified wavelength variance being from about 15 nanometers to about 50 nanometers.
EXAMPLE 22 can include or can optionally be combined with the subject matter of one or any combination of EXAMPLES 1-21, to optionally include each pixel comprising a third gamut-enhancing light-emitting element configured to emit a third gamut-enhancing color having a sixth wavelength that is within a third specified wavelength variance from the second wavelength and a fourth gamut-enhancing light-emitting element configured to emit a fourth gamut-enhancing color having a seventh wavelength that is within a fourth specified wavelength variance from the second wavelength.
EXAMPLE 23 can include or can optionally be combined with the subject matter of one or any combination of EXAMPLES 1-22, to optionally include the third specified wavelength variance being from about 15 nanometers to about 50 nanometers.
EXAMPLE 24 can include or can optionally be combined with the subject matter of one or any combination of EXAMPLES 1-23, to optionally include the fourth specified wavelength variance being from about 15 nanometers to about 50 nanometers.
EXAMPLE 25 can include or can optionally be combined with the subject matter of one or any combination of EXAMPLES 1-24, to optionally include each pixel comprising a fifth gamut-enhancing light-emitting element configured to emit a fifth gamut-enhancing color having an eighth wavelength that is within a fifth specified wavelength variance from the third wavelength and a sixth gamut-enhancing light-emitting element configured to emit a sixth gamut-enhancing color having a ninth wavelength that is within a sixth specified wavelength variance from the third wavelength.
EXAMPLE 26 can include or can optionally be combined with the subject matter of one or any combination of EXAMPLES 1-25, to optionally include the fifth specified wavelength variance being from about 15 nanometers to about 50 nanometers.
EXAMPLE 27 can include or can optionally be combined with the subject matter of one or any combination of EXAMPLES 1-26, to optionally include the sixth specified wavelength variance being from about 15 nanometers to about 50 nanometers.
EXAMPLE 28 can include or can optionally be combined with the subject matter of one or any combination of EXAMPLES 1-27, to include subject matter (such as an apparatus, a device, a method, or one or more means for performing acts), such as can include an electronic display comprising an array of pixels each comprising a first primary light-emitting element configured to emit a first primary color having a first wavelength, a second primary light-emitting element configured to emit a second primary color having a second wavelength, a third primary light-emitting element configured to emit a third primary color having a third wavelength, and wherein the first primary light-emitting element is also configured to cycle between emitting the first primary color having the first wavelength and emitting a first gamut-enhancing color having a fourth wavelength that is within a first specified wavelength variance from the first wavelength, wherein a color gamut that can be produced by the array of pixels is greater than a corresponding color gamut that is produced by a corresponding array of corresponding pixels of corresponding light-emitting elements that are configured to only emit the first primary color having the first wavelength, the second primary color having the second wavelength, and the third primary color having the third wavelength.
EXAMPLE 29 can include or can optionally be combined with the subject matter of one or any combination of EXAMPLES 1-28, to optionally include the first specified wavelength variance being from about 15 nanometers to about 50 nanometers.
EXAMPLE 30 can include or can optionally be combined with the subject matter of one or any combination of EXAMPLES 1-29, to optionally include the first primary light-emitting element being configured to cycle between a first primary drive current to produce the first primary color having the first wavelength and a first gamut-enhancing drive current that is within a first specified current variance from the first primary drive current to produce the first gamut-enhancing color having the fourth wavelength.
EXAMPLE 31 can include or can optionally be combined with the subject matter of one or any combination of EXAMPLES 1-30, to optionally include the second primary light-emitting element being configured to cycle between emitting the second primary color and a second gamut-enhancing color having a fifth wavelength that is within a second specified wavelength from the second wavelength.
EXAMPLE 32 can include or can optionally be combined with the subject matter of one or any combination of EXAMPLES 1-31, to optionally include the second specified wavelength variance being from about 15 nanometers to about 50 nanometers.
EXAMPLE 33 can include or can optionally be combined with the subject matter of one or any combination of EXAMPLES 1-32, to optionally include the second primary light-emitting element being configured to cycle between a second primary drive current to produce the second primary color having the second wavelength and a second gamut-enhancing drive current that is within a second specified current variance from the second primary drive current to produce the second gamut-enhancing color having the fifth wavelength.
EXAMPLE 34 can include or can optionally be combined with the subject matter of one or any combination of EXAMPLES 1-33, to optionally include the third primary light-emitting element being configured to cycle between emitting the third primary color and a third gamut-enhancing color having a sixth wavelength that is within a third specified wavelength from the third wavelength.
EXAMPLE 35 can include or can optionally be combined with the subject matter of one or any combination of EXAMPLES 1-34, to optionally include the third specified wavelength variance being from about 15 nanometers to about 50 nanometers.
EXAMPLE 36 can include or can optionally be combined with the subject matter of one or any combination of EXAMPLES 1-35, to optionally include the third primary light-emitting element being configured to cycle between a third primary drive current to produce the third primary color having the third wavelength and a third gamut-enhancing drive current that is within a third specified current variance from the third primary drive current to produce the third gamut-enhancing color having the sixth wavelength.

The above detailed description includes references to the accompanying drawings, which form a part of the detailed description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims.

## Claims

1. An electronic display comprising:
an array of pixels of light-emitting elements, wherein each pixel is configured to emit a first primary color having a first wavelength, a second primary color having a second wavelength, a third primary color having a third wavelength, and a first gamut-enhancing color having a fourth wavelength that is within a first specified wavelength variance from the first wavelength;
wherein a color gamut that can be produced by the array of pixels is greater than a corresponding array of corresponding pixels of corresponding light-emitting elements that are configured to only emit the first primary color having the first wavelength, the second primary color having the second wavelength, and the third primary color having the third wavelength.

2. An electronic display according to claim 1, wherein each pixel is further configured to emit a second gamut-enhancing color with a fifth wavelength that is within a second specified wavelength variance from the second wavelength, and
wherein each pixel is optionally further configured to emit a third gamut-enhancing color with a sixth wavelength that is within a third specified wavelength variance from the third wavelength.

3. An electronic display according to claim 1 or claim 2, wherein the first wavelength is within a first of a first wavelength range, a second wavelength range, and a third wavelength range; the second wavelength is within a second of the first wavelength range, the second wavelength range, and the third wavelength range; and the third wavelength is within a third of the first wavelength range, the second wavelength range, and the third wavelength range.

4. An electronic display according to claim 3, wherein the first wavelength range is from about 470 nanometers to about 475 nanometers, the second wavelength range is from about 530 nanometers to about 535 nanometers, and the third wavelength range is from about 615 nanometers to about 620 nanometers.

5. An electronic display according to any one of claims 1 to 4, wherein the first specified wavelength variance is from about 15 nanometers to about 50 nanometers.

6. An electronic display according to any one of the preceding claims, wherein each pixel comprises:
a first primary light-emitting element configured to emit the first primary color having the first wavelength,
a second primary light-emitting element configured to emit the second primary color having the second wavelength,
a third primary light-emitting element configured to emit the third primary color having the third wavelength, and
a first gamut-enhancing light-emitting element configured to emit the first gamut-enhancing color having the fourth wavelength that is within the first specified wavelength variance from the first wavelength.

7. An electronic display according to claim 6, wherein each pixel further comprises a second gamut-enhancing light-emitting element configured to emit a second gamut-enhancing color having a fifth wavelength that is within a second specified wavelength variance from the second wavelength, and
wherein each pixel optionally further comprises a third gamut-enhancing light-emitting element configured to emit a third gamut-enhancing color having a sixth wavelength that is within a third specified wavelength variance from the third wavelength.

8. An electronic display according to claim 6, wherein each pixel comprises:
a second gamut-enhancing light-emitting element configured to emit a second gamut-enhancing color having a fifth wavelength that is within a second specified wavelength variance from the first wavelength.

9. An electronic display according to claim 8, wherein each pixel further comprises:
a third gamut-enhancing light-emitting element configured to emit a third gamut-enhancing color having a sixth wavelength that is within a third specified wavelength variance from the second wavelength; and
a fourth gamut-enhancing light-emitting element configured to emit a fourth gamut-enhancing color having a seventh wavelength that is within a fourth specified wavelength variance from the second wavelength.

10. An electronic display according to claim 9, wherein each pixel further comprises:
a fifth gamut-enhancing light-emitting element configured to emit a fifth gamut-enhancing color having an eighth wavelength that is within a fifth specified wavelength variance from the third wavelength; and
a sixth gamut-enhancing light-emitting element configured to emit a sixth gamut-enhancing color having a ninth wavelength that is within a sixth specified wavelength variance from the third wavelength.

11. An electronic display according to any one of claims 1 to 5, wherein each pixel comprises:
a first primary light-emitting element configured to emit the first primary color having the first wavelength,
a second primary light-emitting element configured to emit the second primary color having the second wavelength,
a third primary light-emitting element configured to emit the third primary color having the third wavelength, and
wherein the first primary light-emitting element is configured to cycle between emitting the first primary color having the first wavelength and emitting the first gamut-enhancing color having the fourth wavelength.

12. An electronic display according to claim 11, wherein the first primary light-emitting element is configured to cycle between a first primary drive current and a first gamut-enhancing drive current that is within a first specified current variance from the first primary drive current.

13. An electronic display according to claim 11, wherein the second primary light-emitting element is configured to cycle between emitting the second primary color and a second gamut-enhancing color having a fifth wavelength that is within a second specified wavelength variance from the second wavelength.

14. An electronic display according to claim 13, wherein the second primary light-emitting element is configured to cycle between a second primary drive current and a second gamut-enhancing drive current that is within a second specified current variance from the second primary drive current.

15. An electronic display according to claim 13, wherein the third primary light-emitting element is configured to cycle between emitting the third primary color and a third gamut-enhancing color having a sixth wavelength that is within a third specified wavelength variance from the third wavelength, and
wherein the third primary light-emitting element is optionally configured to cycle between a third primary drive current and a third gamut-enhancing drive current that is within a third specified current variance from the third primary drive current.
